# EUROPEAN PATENT SPECIFICATION

(11) **EP 3 851 864 B1**
(45) Date of publication and mention of the grant of the patent: **28.06.2023**
(21) Application number: 19861085.9
(22) Date of filing: 22.03.2019
(51) Int. Cl.: G01R 33/09, G01R 33/02, G01R 15/20, G01R 33/00, G01R 1/18

(54) **MAGNETIC SENSOR AND CURRENT SENSOR**
MAGNETSENSOR UND STRÖMUNGSSENSOR
CAPTEUR MAGNÉTIQUE ET CAPTEUR DE COURANT

(30) Priority: 12.09.2018 JP 2018170701
(43) Date of publication of application: 21.07.2021
(73) Proprietor: Alps Alpine Co., Ltd., Tokyo 145-8501 (JP)
(72) Inventor: ICHINOHE, Kenji, Tokyo 145-8501 (JP)
(74) Representative: Schmitt-Nilson Schraud Waibel Wohlfrom Patentanwälte Partnerschaft mbB
(86) International application number: PCT/JP2019/012101
(87) International publication number: WO 2020/054112

(56) References cited:
- WO-A1-2017/169156
- JP-A- 2004 020 371
- JP-A- 2008 300 851
- JP-A- 2014 181 981
- JP-A- 2018 112 481
- US-A1- 2011 080 165
- US-A1- 2013 057 273
- US-A1- 2018 220 927

## Description

### Technical Field

The present invention relates to a magnetic sensor and a current sensor including the magnetic sensor.

### Background Art

Fields relating to, for example, motor drive technology for electric vehicles and hybrid vehicles and infrastructure, such as pole transformers, use relatively large currents and require current sensors capable of measuring a large current in a non-contact manner. Such current sensors include a known current sensor including a magnetic sensor that detects a magnetic field from a target current to be measured. Examples of magnetic detecting elements for magnetic sensors include magnetoresistive elements, such as a giant magnetoresistive (GMR) element.

The magnetoresistive elements feature high detection sensitivity but have a relatively small range of detectable magnetic field strengths because of high output-linearity. For this reason, the following approach may be used. A magnetic shield is disposed between the target current and the magnetoresistive element to reduce the strength of a magnetic field substantially applied to the magnetoresistive element so that the magnitude of a target magnetic field to be measured lies within the range of magnetic field strengths providing good detection characteristics. PTL 1 discloses a current sensor with such a configuration as illustrated in Fig. 3 of PTL 1.

As described above, the magnetic shield is used to reduce the strength of a magnetic field substantially applied to magnetoresistive elements, thus increasing the range of magnetic field strengths to be measured. Unfortunately, the magnetic shield may cause magnetic hysteresis. PTL 2 describes that a hard bias layer made of a hard magnetic material and disposed over a magnetic shield reduces the magnetic hysteresis and thus improves the linearity of an output of a magnetoresistive element.

### Citation List

### Patent Literature

PTL 1: International Publication No. WO 2011/111493
PTL 2: International Publication No. WO 2011/155261

US 2013/057273 A1 discloses a current sensor which includes a magnetoresistive element and magnetic shields arranged between a current line and the magnetoresistive element.

US 2011/080165 A1 discloses a magnetic balance type current sensor which measures a measured current which flows in a feedback coil when electrical conduction is provided by a voltage difference according to an induction magnetic field from the measured current and an equilibrium state is reached in which the induction magnetic field and a cancel magnetic field cancel each other.

### Summary of Invention

### Technical Problem

It is, however, difficult to accurately form a hard bias layer made of a hard magnetic material. For this reason, it is preferred in terms of production efficiency and production costs that a component other than the hard bias layer be used to reduce magnetic hysteresis caused by a magnetic shield.

The present invention has been made in consideration of the above-described circumstances and aims to provide a magnetic sensor that includes a magnetic shield and a magnetoresistive element and in which the likelihood that the magnetoresistive element may decrease in measurement accuracy when a large magnetic field is applied to the magnetic sensor is reduced without using a hard bias layer. The present invention further aims to provide a current sensor including the magnetic sensor.

### Solution to Problem

An embodiment of the present invention provides a magnetic sensor including at least one magnetoresistive element, a magnetic shield facing the magnetoresistive element and reducing the strength of a target magnetic field that is applied to the magnetoresistive element and is to be measured, and at least one magnetic generating means electrically connected to the magnetoresistive element, wherein the magnetic generating means generates a magnetic field in response to power supply to the magnetic generating means and the magnetoresistive element, and the magnetic field causes a bias magnetic field to be applied to the magnetic shield.

The bias magnetic field in a direction orthogonal to the axis of sensitivity of the magnetoresistive element is applied to the magnetic shield to form a single magnetic domain in the magnetic shield, reducing or eliminating remanent magnetization in a direction along the axis of sensitivity. This results in a reduction in hysteresis of an output of the magnetic sensor.

The magnetic shield has a rectangular shape having a lengthwise direction and a widthwise direction in plan view, the magnetoresistive element has an axis of sensitivity in the widthwise direction, and the magnetic field caused by the magnetic generating means flows through the magnetic shield in the lengthwise direction. Preferably, the magnetoresistive element and the magnetic generating means are arranged in the lengthwise direction in plan view, and the magnetoresistive element is closer to the center of the magnetic shield than the magnetic generating means in the lengthwise direction. Such configurations lead to a reduction in hysteresis of an output of the magnetic sensor.

Preferably, the magnetic generating means and the magnetoresistive element are located on the same substrate flat surface. Such a configuration leads to higher production efficiency of the magnetic sensor.

Preferably, the magnetic sensor has a configuration in which the at least one magnetic generating means includes two magnetic generating means, and the two magnetic generating means generate magnetic fields in opposite directions.

In this configuration, preferably, the at least one magnetoresistive element includes a plurality of magnetoresistive elements forming a bridge circuit, and the magnetic generating means are arranged between the bridge circuit and a feeding terminal and between the bridge circuit and a grounding terminal. In response to power supply to the bridge circuit through the feeding terminal and the grounding terminal, one of the magnetic generating means generates a magnetic field in a direction toward the magnetic shield, and the other magnetic generating means generates a magnetic field in a direction away from the magnetic shield.

Preferably, the magnetic generating means are flat coils located on the same substrate flat surface as a substrate flat surface on which the magnetoresistive elements are located, and the two magnetic generating means are wound in directions opposite to each other.

Such configurations enable the magnetic fields generated from the magnetic generating means to achieve efficient application of the bias magnetic field to the magnetic shield.

Preferably, the magnetic sensor has a configuration in which the magnetic shield has a rectangular shape having a lengthwise direction and a widthwise direction in plan view, and opposite ends of the magnetic shield in the lengthwise direction respectively overlap the two magnetic generating means in plan view.

This configuration enables the entire magnetic shield to have a single magnetic domain.

Another embodiment of the present invention provides a current sensor including the above-described magnetic sensor, wherein the target magnetic field in the magnetic sensor is a magnetic field from a target current to be measured.

### Advantageous Effects of Invention

The present invention provides the configuration in which the magnetic generating means causes the bias magnetic field to be applied to the magnetic shield in response to power supply to the magnetoresistive element. This configuration can reduce the effects of an applied magnetic field on the magnetic shield if the magnetic shield has remanent magnetization. Thus, the effects of a circulating magnetic field, which is based on the remanent magnetization in the magnetic shield, on the magnetoresistive element can be reduced without using a hard bias layer. Therefore, the magnetic sensor in which the magnetoresistive element is less likely to decrease in measurement accuracy is provided. In addition, the current sensor including the magnetic sensor is provided.

### Brief Description of Drawings

[Fig. 1] Fig. 1 is a perspective view conceptually illustrating the structure of a magnetic sensor according to an embodiment of the present invention.
[Fig. 2] Fig. 2 is a schematic sectional view of a multilayer structure of a magnetoresistive element.
[Fig. 3] (a) is a schematic plan view of an initial magnetic domain state of a magnetic shield, (b) is a schematic plan view of a magnetic domain state thereof after application of a noise magnetic field, and (c) is a schematic plan view of a magnetic domain state thereof after application of a bias magnetic field.
[Fig. 4] Fig. 4 is a sectional view as viewed in a direction of arrows V1-V1 in Fig. 3(b) and schematically illustrates the effects of a remanent magnetic field in the magnetic shield on a magnetoresistive element.
[Fig. 5] Fig. 5 is a plan view of a magnetic sensor according to an embodiment of the present invention when viewed from the side where the magnetic shield is disposed and illustrates a positional relationship.
[Fig. 6] Fig. 6 is a perspective view conceptually illustrating the structure of a magnetic sensor according to another embodiment of the present invention.
[Fig. 7] Fig. 7 is a plan view conceptually illustrating the structure of a magnetic sensor according to another embodiment of the present invention.
[Fig. 8] Fig. 8 is a sectional view of the magnetic sensor as viewed in a direction of arrows V2-V2 in Fig. 7. Description of Embodiments

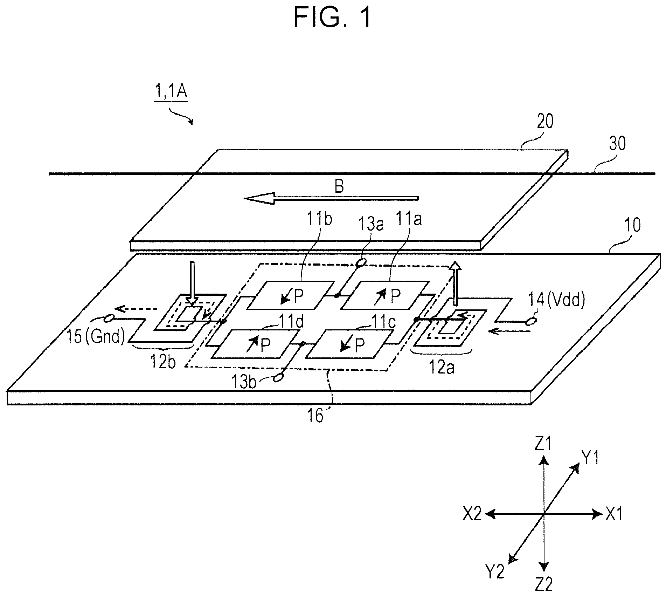

Fig. 1 is a perspective view conceptually illustrating the structure of a magnetic sensor according to an embodiment of the present invention. As illustrated in Fig. 1, a magnetic sensor 1 according to an embodiment of the present invention includes magnetoresistive elements 11a, 11b, 11c, and 11d (hereinafter, appropriately referred to as magnetoresistive elements 11 when not distinguished from one another) and a magnetic shield 20 facing the magnetoresistive elements 11.

Each of the four magnetoresistive elements 11 of the magnetic sensor 1 includes a giant magnetoresistive element (GMR element) having a meandering shape (shape defined by multiple elongated parts extending in an X1-X2 direction and combined into a folded pattern). Each of the four magnetoresistive elements 11 has a sensitivity axis direction P represented by an arrow in Fig. 1. The sensitivity axis directions P of the magnetoresistive elements 11 are set such that the sensitivity axis direction P of the magnetoresistive elements 11a and 11d is oriented to a Y1 side in a Y1-Y2 direction and the sensitivity axis direction P of the magnetoresistive elements 11b and 11c is oriented to a Y2 side in the Y1-Y2 direction.

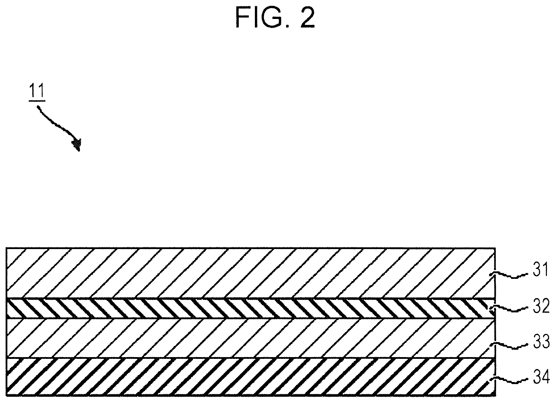

Fig. 2 is a schematic sectional view illustrating a multilayer structure of each magnetoresistive element 11. As illustrated in Fig. 2, the four magnetoresistive elements 11 each have a multilayer structure including a fixed magnetic layer 31, a non-magnetic layer 32, and a free magnetic layer 33. The resistance of each magnetoresistive element changes depending on the relationship between the fixed magnetic layer 31 whose magnetization direction is fixed in the sensitivity axis direction P (refer to Fig. 1) and the orientation of magnetization of the free magnetic layer 33 whose magnetization direction changes depending on an external magnetic field. The orientation and strength of the external magnetic field can be detected by detecting a change in resistance.

Movement of a magnetic domain wall in the free magnetic layer 33 made of a soft magnetic material causes Barkhausen noise. To stabilize an output of the magnetic sensor 1, an exchange bias magnetic field based on an exchange coupling field with an antiferromagnetic layer 34 is applied in a direction orthogonal to the sensitivity axis direction P of each of the four magnetoresistive elements 11. The exchange bias magnetic field applied to the free magnetic layer 33 can align the magnetization directions of the free magnetic layers 33 of the four magnetoresistive elements 11.

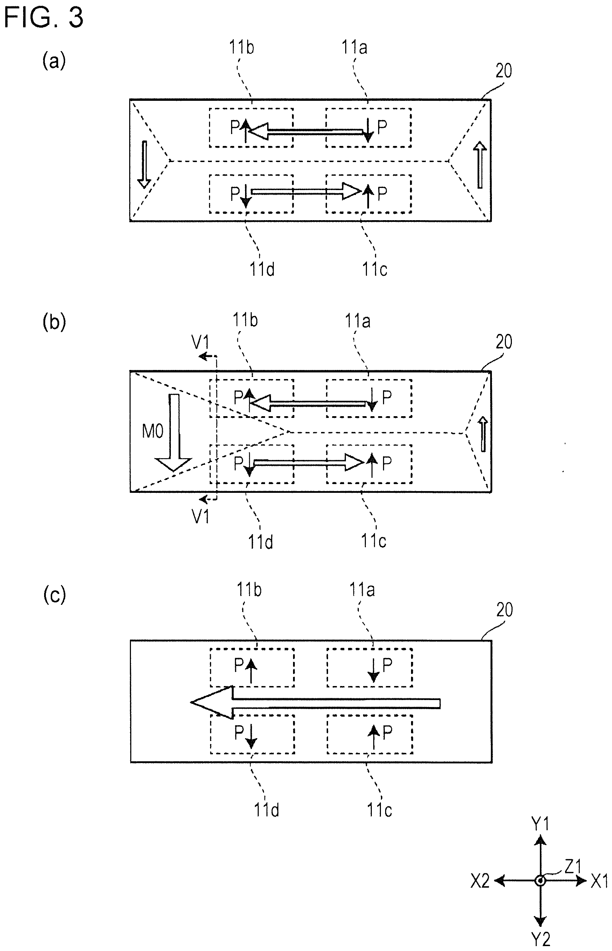

Figs. 3(a) to 3(c) are schematic plan views illustrating magnetic domain states of the magnetic shield 20. Fig. 3(a) illustrates an initial magnetic domain state. Fig. 3(b) illustrates a magnetic domain state after application of a noise magnetic field. Fig. 3(c) illustrates a magnetic domain state after application of a bias magnetic field.

In the magnetic sensor 1 according to the embodiment of the present invention, the magnetic shield 20 functions to reduce the strength of a target magnetic field that is applied to the magnetoresistive elements 11 and is to be measured. As illustrated in Fig. 1 and Figs. 3(a) to 3(c), the magnetic shield 20 has a rectangular shape having a lengthwise direction (X1-X2 direction) orthogonal to the sensitivity axis directions P (Y1-Y2 direction) and a widthwise direction along the sensitivity axis directions P (Y1-Y2 direction) in plan view (viewed in a Z1-Z2 direction). The magnetoresistive elements 11a to 11d are arranged inside a region defined by the rectangular shape.

Initially, the magnetic shield 20 has closure domains as illustrated in Fig. 3(a). Magnetic domains parallel to the sensitivity axis directions P are very small. Magnetic domains over the magnetoresistive elements 11 are orthogonal to the sensitivity axis directions P. Therefore, the effects of the magnetic domains of the magnetic shield 20 on the sensitivities of the magnetoresistive elements 11 are very small.

However, for example, applying a strong magnetic field as a noise magnetic field to the Y2 side in the Y1-Y2 direction increases the magnetic domain in the direction in which the noise magnetic field is applied. After application of the noise magnetic field, the effects of the noise magnetic field may remain, causing remanent magnetization M0 as illustrated in Fig. 3(b). In this case, a magnetic domain parallel to the sensitivity axis directions P overlaps the magnetoresistive elements 11, increasing the effects of the remanent magnetization M0 on the magnetoresistive elements 11.

For reduction of the remanent magnetization M0 in this case, it is important to reduce or eliminate factors that hinder movement of the magnetic domain walls in the magnetic shield 20. For this reason, the magnetic shield 20 is typically made of an amorphous or nanocrystalline soft magnetic material, in which magnetic domain walls are easily movable after application of a noise magnetic field, with small magnetic anisotropy and no grain boundary. However, such a material does not sufficiently reduce or eliminate the effects of the remanent magnetization M0.

The magnetic shield 20 has a length in the X1-X2 direction. The effect of shape magnetic anisotropy allows magnetization in the Y1-Y2 direction, serving as the widthwise direction, to be less likely to occur than magnetization in the X1-X2 direction, serving as the lengthwise direction. However, a strong external magnetic field may cause remanent magnetization M0 in the Y1-Y2 direction, serving as the widthwise direction.

As illustrated in Fig. 1, the magnetic sensor 1 according to the embodiment includes two flat coils (magnetic generating means) 12a and 12b electrically connected to the magnetoresistive elements 11. Magnetic fields generated from the flat coils 12a and 12b in response to power supply to the magnetoresistive elements 11 are applied as a bias magnetic field B to the magnetic shield 20. Applying the bias magnetic field B removes the effects of the noise magnetic field, causing the magnetic shield 20 to have a single magnetic domain as illustrated in Fig. 3(c). This prevents remanent magnetization M0 from occurring in the magnetic shield 20 when a noise magnetic field is applied to the magnetic shield, thus preventing a reduction in detection sensitivity of the magnetoresistive elements 11.

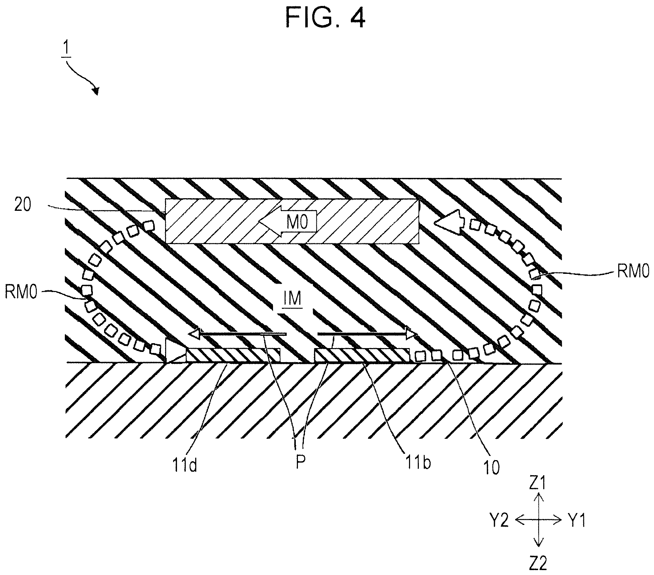

Fig. 4 is a sectional view of the magnetic sensor 1 in Fig. 3(b), in which remanent magnetization is oriented to the Y2 side in the Y1-Y2 direction, taken along a plane containing the Y1-Y2 axis and the Z1-Z2 axis as viewed in a direction of arrows V1-V1, and schematically illustrates the effects of a remanent magnetic field in the magnetic shield 20 on the magnetoresistive element 11d.

As illustrated in Fig. 4, the magnetoresistive elements 11 are located on a substrate flat surface 10 and are covered with an insulating layer IM made of an insulating material (such as alumina or silicon nitride). The magnetic shield 20 is disposed over the magnetoresistive elements 11 (on a Z1 side in the Z1-Z2 direction) at a distance from the magnetoresistive elements 11. The distance between the magnetic shield 20 and the magnetoresistive elements 11 is adjusted by using the thickness of the insulating layer IM located therebetween.

Remanent magnetization M0 in the magnetic shield 20 causes a magnetic field (circulating magnetic field RM0) based on the remanent magnetization M0 to be applied to the magnetoresistive elements 11 in a direction (to the Y1 side in the Y1-Y2 direction) opposite to the orientation of the remanent magnetization M0. The circulating magnetic field RM0 causes offset, leading to a reduction in measurement accuracy of the magnetic sensor 1. In such a case, feeding a current to a bridge circuit 16 (refer to Fig. 1) enables the remanent magnetization M0 in the magnetic shield 20 to be removed by using, as a bias magnetic field B, magnetic fields generated from the flat coils 12a and 12b. This can eliminate or reduce the application of the circulating magnetic field RM0 based on the remanent magnetization M0 to the magnetoresistive elements 11. Therefore, reducing or eliminating fluctuations in characteristics of the magnetic shield 20 caused by application of a strong magnetic field or removing the fluctuations allows the magnetic sensor 1 including the magnetoresistive elements 11 to exhibit higher measurement accuracy than a magnetic sensor including no flat coils 12a and 12b.

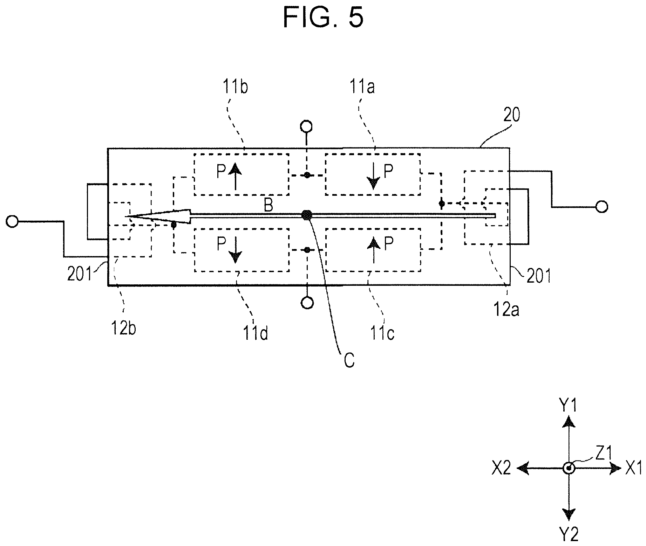

Fig. 5 is a plan view of a magnetic sensor according to an embodiment of the present invention when viewed from the side (Z1 side of the Z1-Z2 axis) in which the magnetic shield 20 is disposed and illustrates a positional relationship. As illustrated in Fig. 5, opposite ends 201 of the magnetic shield 20 in the lengthwise direction are located to overlap the flat coils 12a and 12b in plan view as seen from the side in which the magnetic shield 20 is disposed. This arrangement allows magnetic fields that are generated from the flat coils 12a and 12b in response to power supply to the bridge circuit 16 to be efficiently applied, as the bias magnetic field B, to the entire magnetic shield 20. This results in an increase in measurement accuracy of the magnetic sensor 1.

The sensitivity axis direction P of each magnetoresistive element 11 is along the widthwise direction of the magnetic shield 20. The bias magnetic field B caused by the flat coils 12a and 12b flows through the magnetic shield 20 in the lengthwise direction of the magnetic shield 20. The magnetoresistive elements 11 and the flat coils 12a and 12b are arranged in the lengthwise direction of the magnetic shield 20 in plan view. The magnetoresistive elements 11 are located closer to the center C, serving as the intersection of diagonals, of the magnetic shield 20 than the flat coils 12a and 12b in the lengthwise direction.

As illustrated in Fig. 1, the flat coil 12a is disposed between the bridge circuit 16 including the four magnetoresistive elements and a feeding terminal 14, and the flat coil 12b is disposed between the bridge circuit 16 and a grounding terminal 15. Power supply from the feeding terminal 14 and the grounding terminal 15 to the bridge circuit 16 through the flat coil 12a and the flat coil 12b causes current to flow through the flat coils 12a and 12b, thus causing the flat coils 12a and 12b to generate magnetic fields. The flat coils 12a and 12b are wound in directions opposite to each other. The flat coil 12a, which is one of the two flat coils, generates a magnetic field in a direction toward the magnetic shield 20. The flat coil 12b, which is the other one of the two flat coils, generates a magnetic field in a direction away from the magnetic shield 20. In Fig. 1, dashed-line arrows each represent a current direction. Although Fig. 1 illustrates an exemplary configuration in which the flat coils 12a and 12b and the bridge circuit 16 are connected in series, any configuration in which the flat coils 12a and 12b and the bridge circuit 16 are supplied with power together may be used. For example, the flat coils 12a and 12b may be connected in parallel with the bridge circuit 16.

The magnetic fields generated from the flat coils 12a and 12b in the directions toward and away from the magnetic shield 20 cause the bias magnetic field B orthogonal to the sensitivity axis directions P of the magnetoresistive elements 11 to be applied to the magnetic shield 20. The magnetic sensor 1 can apply the bias magnetic field B to the magnetic shield 20 by using the magnetic fields from the flat coils 12a and 12b connected to the bridge circuit 16 without including a hard bias layer made of a permanent magnet.

If magnetic generating means are configured as the flat coils 12a and 12b as described above, the magnetic generating means and the magnetoresistive elements 11 can be located on the same substrate flat surface 10. For such a configuration, the flat coils 12a and 12b for causing the bias magnetic field B and the bridge circuit 16 can be simultaneously formed by a thin-film process. In addition, the arrangement (layout) of the flat coils 12a and 12b relative to the magnetic shield 20 can be used to apply the bias magnetic field B to the magnetic shield 20 in any direction. Since the flat coils 12a and 12b are wound in the directions opposite to each other in the embodiment, no induced electromotive force is generated from the flat coils 12a and 12b by a noise magnetic field along the Z1-Z2 axis.

As illustrated in Fig. 1, the bridge circuit 16 includes the magnetoresistive elements 11a and 11b having different sensitivity axis directions P and connected in series and the magnetoresistive elements 11c and 11d having different sensitivity axis directions P and connected in series such that series connections of the magnetoresistive elements are connected in parallel. A potential at the mid-point of each series connection changes depending on the strength and orientation of a magnetic field to the bridge circuit 16. Therefore, the strength and orientation of a magnetic field (target magnetic field) from a target current Io, which is to be measured, flowing through a current line 30 can be determined by comparing a potential of a mid-point potential measurement terminal 13a for the magnetoresistive elements 11a and 11b connected in series with a potential of a mid-point potential measurement terminal 13b for the magnetoresistive elements 11c and 11d connected in series.

The magnetic sensor 1 according to the present invention includes the flat coils 12a and 12b that cause the bias magnetic field B, which reduces or eliminates fluctuations in characteristics of the magnetic shield 20 caused by application of a strong magnetic field. This configuration enables the bias magnetic field B, which is produced in response to power supply to the bridge circuit 16, to reduce or eliminate remanent magnetization M0 caused by a strong external magnetic field, thus preventing a reduction in measurement accuracy of the magnetic sensor 1 caused by the magnetic shield 20.

To reduce or eliminate the formation of multiple magnetic domains in the free magnetic layer 33 (refer to Fig. 2) caused by a strong external magnetic field, a bias magnetic field may be applied to the four magnetoresistive elements 11. Increasing the bias magnetic field is effective in reducing or eliminating the formation of multiple magnetic domains in the free magnetic layer 33 but reduces an output as the difference in potential between the mid-point potential measurement terminals 13a and 13b (refer to Fig. 1). In terms of enhancing the sensitivity of the magnetic sensor 1, therefore, it is not preferred to increase the bias magnetic field that is applied to the free magnetic layer 33.

The flat coils 12a and 12b of the magnetic sensor 1 according to the present invention are arranged on the same substrate flat surface 10 as that on which the bridge circuit 16 is disposed. Therefore, the bridge circuit 16 and the flat coils 12a and 12b can be simultaneously formed on the same substrate flat surface 10. This configuration, in which the bridge circuit 16 and the flat coils 12a and 12b are arranged on the same surface, allows the bias magnetic field B to be applied to the magnetic shield 20 without using a dedicated circuit different from the bridge circuit 16. Thus, the above-described configuration is advantageous in terms of reducing costs required to produce the magnetic sensor 1.

As illustrated in Fig. 5, it is preferred that the four magnetoresistive elements 11 be completely covered with the magnetic shield 20 in plan view (when viewed from the Z1 side in the Z1-Z2 direction). This arrangement can more stably eliminate or reduce the application of the circulating magnetic field RM0 (refer to Fig. 4) based on the remanent magnetization M0 in the magnetic shield 20 to the four magnetoresistive elements 11.

The magnetic shield 20 can have, for example, a single-layer structure made only of a soft magnetic layer or a multilayer structure including an underlying layer serving as a lower surface (located on a Z2 side in the Z1-Z2 direction) of the magnetic shield 20 and made of a soft magnetic material and a soft magnetic layer formed on the underlying layer (on the Z1 side in the Z1-Z2 direction). The magnetic shield 20 may further include a protective oxide layer made of, for example, tantalum (Ta) on the soft magnetic layer (on the Z1 side in the Z1-Z2 direction). For the multilayer structure, each of the underlying layer and the soft magnetic layer is made of a soft magnetic material containing an iron-group element, such as Fe, Co, or Ni. The thickness of the underlying layer is set to any value. The thickness of the soft magnetic layer is set to any value so that the magnetic shield 20 has a predetermined magnetic shielding function. Non-limiting examples of the thickness of the soft magnetic layer include a thickness of from 1 to 50 µm. In some cases, the thickness of the soft magnetic layer is preferably from 5 to 30 µm, more preferably from 10 to 25 µm.

The aspect ratio of the magnetic shield 20 is the ratio of the dimension in the lengthwise direction (X1-X2 direction) of the magnetic shield 20 to the dimension in the widthwise direction (Y1-Y2) thereof. Increasing the aspect ratio of the magnetic shield 20 increases an anisotropic magnetic field Hk of the magnetic shield 20, thus increasing a linear region of a magnetization curve of the magnetic shield 20 along the sensitivity axis of the magnetic sensor 1. This results in an increase in linear region of an output of the magnetic sensor 1, leading to a larger dynamic range of the magnetic sensor 1.

The magnetic shield 20 can be fabricated in any manner. Non-limiting examples include a method of forming an underlying layer by dry processing such as sputtering and wet processing such as electroless plating, forming a resist layer patterned in a predetermined shape on the underlying layer, and then forming a soft magnetic layer using, as a conductive layer, the exposed underlying layer by electroplating.

Using the flat coils 12a and 12b as magnetic field generating means enables magnetic fields to be efficiently generated in response to power supply to the bridge circuit 16. Since the two flat coils 12a and 12b in total are arranged such that one flat coil is disposed at each side of the bridge circuit 16, the magnetic fields can be efficiently generated.

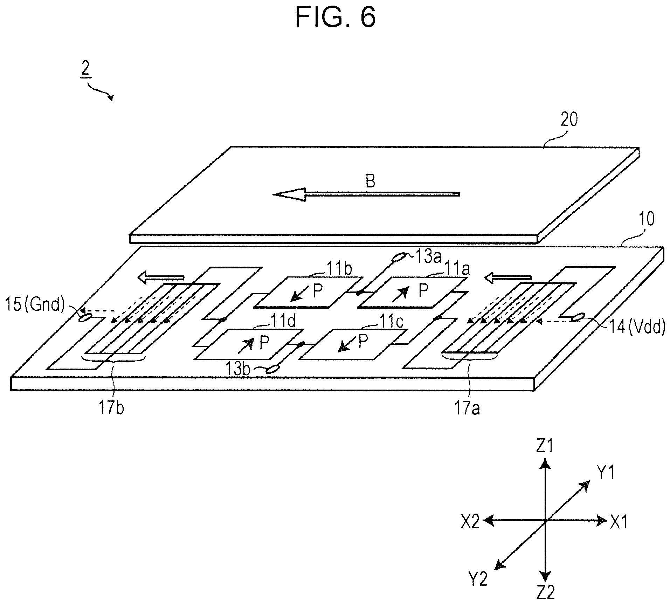

Fig. 6 is a perspective view conceptually illustrating the structure of a magnetic sensor 2 according to another embodiment of the present invention. The magnetic sensor 2 of Fig. 6 differs from the magnetic sensor 1 in that the magnetic sensor 2 includes magnetic generating means 17a and 17b, each of which is composed of a comb-shaped wiring pattern, instead of the flat coils 12a and 12b. The magnetic generating means are not limited to the flat coils because any magnetic generating means configured to apply the bias magnetic field B to the magnetic shield 20 may be used. Only one magnetic generating means may be disposed.

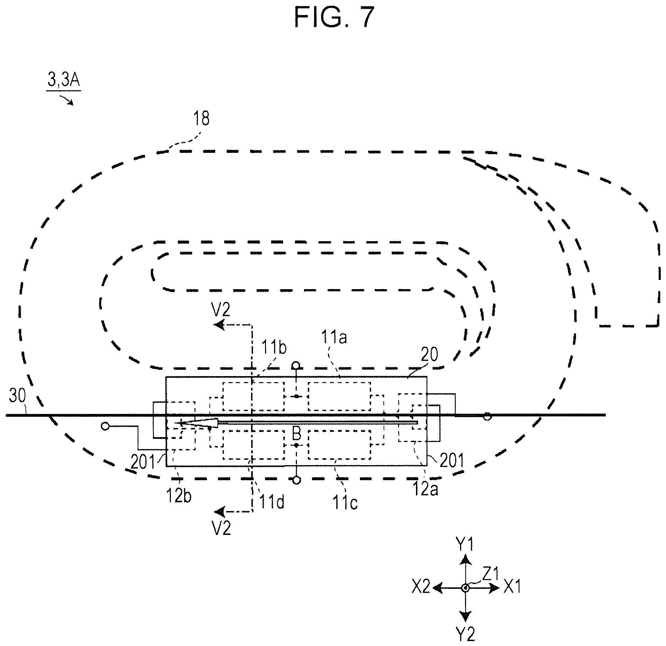

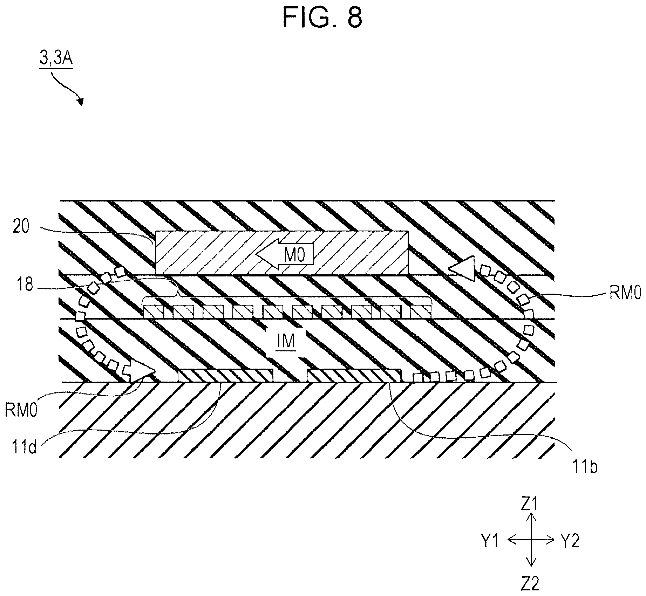

Fig. 7 is a plan view conceptually illustrating the structure of a magnetic sensor 3 according to another embodiment of the present invention. Fig. 8 is a sectional view of the magnetic sensor as viewed in a direction of arrows V2-V2 in Fig. 7. The magnetic sensor 3 illustrated in Figs. 7 and 8 is similar to the magnetic sensor 1 of Fig. 1 in terms of including the magnetoresistive elements 11a to 11d and the magnetic shield 20. The magnetic sensor 3 differs from the magnetic sensor 1 in that the magnetic sensor 3 includes a spiral-shaped, magnetic balance flat coil (spiral flat coil) 18 disposed between the magnetoresistive elements and the magnetic shield 20.

In Fig. 7, the outline of the magnetic balance flat coil 18 is represented by a bold dashed line. The flat coil is wound on an X-Y plane in a region defined by the dashed line. Referring to Fig. 8, the cross-sections of wound flat coil parts of the magnetic balance flat coil 18 are arranged in the Y1-Y2 direction. The magnetic balance flat coil 18, which is disposed between the magnetoresistive elements 11 and the magnetic shield 20, can generate a magnetic field with a relatively small current so that the generated magnetic field cancels out an externally applied magnetic field attenuated by the magnetic shield 20. Thus, the magnetic sensor of a magnetic balance system can be operated with lower power consumption.

Although the four magnetoresistive elements 11 included in the magnetic sensor 1, 2, and 3 are GMR elements as concrete examples in the above-described embodiments, the magnetoresistive elements 11 are not limited to the above-described examples. As a non-limiting example, the magnetoresistive element includes at least one element selected from the group consisting of an anisotropic magnetoresistive element (AMR element), a giant magnetoresistive element (GMR element), and a tunneling magnetoresistive element (TMR element).

The magnetic sensors 1, 2, and 3 including the magnetoresistive elements according to the embodiments of the present invention are suitably available as current sensors. In other words, the present invention can embody a current sensor including the magnetic sensor 1, 2, or 3 in which the target magnetic field is a magnetic field from a target current to be measured.

Concrete examples of a current sensor according to an embodiment of the present invention include a magnetic proportional current sensor and a magnetic balance current sensor.

A concrete example of the magnetic proportional current sensor is a current sensor including the magnetic sensor 1 of Fig. 1. In such a current sensor (magnetic proportional current sensor 1A), the current line 30 through which the target current Io flows is located over the magnetic shield 20 illustrated in Fig. 1 (on the Z1 side in the Z1-Z2 direction) and extends in the X1-X2 direction. A magnetic field, which is a target magnetic field to be measured, from the target current Io is applied to the magnetoresistive elements 11 in the direction along the sensitivity axis directions P (Y1-Y2 direction). Part of the target magnetic field passes through the magnetic shield 20 having higher permeability, leading to a reduction in strength of the target magnetic field substantially applied to the magnetoresistive elements 11. This can increase the measurement range of the magnetic sensor 1. Furthermore, the bias magnetic field B caused by the magnetic fields from the flat coils 12a and 12b arranged on the substrate flat surface 10 can reduce or remove the remanent magnetization M0 in the magnetic shield 20. Therefore, the flat coils 12a and 12b can reduce the effects of the circulating magnetic field RM0, based on the remanent magnetization M0, on the four magnetoresistive elements 11.

In one preferred example, the magnetic proportional current sensor 1A includes a magnetic-field detection bridge circuit including four magnetoresistive elements 11 and two outputs providing a potential difference based on a target magnetic field that is a magnetic field from the target current Io. The magnetic proportional current sensor 1A including the bridge circuit determines the target current Io based on a potential difference that is based on the target magnetic field and output from the magnetic-field detection bridge circuit.

A concrete example of the magnetic balance current sensor is a magnetic balance current sensor 3A including the magnetic sensor 3 illustrated in Figs. 7 and 8. In the magnetic balance current sensor 3A, the current line 30 through which the target current Io flows is located over the magnetic shield 20 illustrated in Fig. 7 (on the Z1 side in the Z1-Z2 direction) and extends in the X1-X2 direction. A magnetic field, which is a target magnetic field to be measured, from the target current Io is applied to the magnetoresistive elements 11 in the direction along the sensitivity axis directions P (Y1-Y2 direction). Part of the target magnetic field passes through the magnetic shield 20 having higher permeability, leading to a reduction in strength of the target magnetic field substantially applied to the magnetoresistive elements 11. This can reduce a current flowing through the magnetic balance flat coil 18 to generate a magnetic field that cancels out a magnetic field from the target current Io and substantially applied to the magnetoresistive elements 11, thus achieving lower power consumption of the current sensor.

In one preferred example, the magnetic balance current sensor 3A includes the magnetic sensor 3 including the four magnetoresistive elements 11 and having a magnetic-field detection bridge circuit. The magnetic-field detection bridge circuit has two outputs providing a potential difference based on the target magnetic field, which is the magnetic field from the target current Io, and a magnetic field generated from the magnetic balance flat coil 18 and applied to cancel out the target magnetic field. In the magnetic balance current sensor 3A including the magnetic-field detection bridge circuit, the target current Io is measured based on a current that flows through the magnetic balance flat coil 18 when the potential difference output from the magnetic-field detection bridge circuit is equal to zero.

The above-described embodiments are intended for easy understanding of the present invention and are not intended for limiting the present invention as defined by the appended claims.

### Industrial Applicability

A magnetic sensor including a magnetoresistive element according to an embodiment of the present invention is suitably available as a component of a current sensor for infrastructure, such as a pole transformer, or a component of a current sensor for an electric vehicle or a hybrid vehicle, for example.

### Reference Signs List

- 1, 2, 3: magnetic sensor
- 1A, 3A: current sensor
- 10: substrate flat surface
- 11, 11a, 11b, 11c, 11d: magnetoresistive element
- 12a, 12b: flat coil (magnetic generating means)
- 13a, 13b: mid-point potential measurement terminal
- 14: feeding terminal
- 15: grounding terminal
- 16: bridge circuit
- 17a, 17b: magnetic generating means
- 18: magnetic balance flat coil
- 20: magnetic shield
- 201: end
- 30: current line
- 31: fixed magnetic layer
- 32: non-magnetic layer
- 33: free magnetic layer
- 34: antiferromagnetic layer
- P: sensitivity axis direction
- B: bias magnetic field
- C: center
- IM: insulating layer
- M0: remanent magnetization
- RM0: circulating magnetic field

## Claims

1. A magnetic sensor (1, 2, 3) comprising at least one magnetoresistive element (11), a magnetic shield (20) facing the magnetoresistive element (11) and reducing a strength of a target magnetic field that is applied to the magnetoresistive element (11) and is to be measured, and at least one magnetic generating means (12a, 12b) electrically connected to the magnetoresistive element (11),
wherein the magnetic generating means (12a, 12b) generates a magnetic field in response to power supply to the magnetic generating means (12a, 12b) and the magnetoresistive element (11),
wherein the magnetic shield (20) has a rectangular shape having a lengthwise direction and a widthwise direction in plan view, the magnetoresistive element (11) has an axis of sensitivity in the widthwise direction,
**characterised in that**
the magnetic field caused by the magnetic generating means (12a, 12b) flows through the magnetic shield (20) in the lengthwise direction, and
the magnetic field causes a bias magnetic field to be applied to the magnetic shield (20) to form a single magnetic domain in the magnetic shield (20).

2. The magnetic sensor according to Claim 1, wherein the magnetoresistive element (11) and the magnetic generating means (12a, 12b) are arranged in the lengthwise direction in plan view, and the magnetoresistive element (11) is closer to a center of the magnetic shield (20) than the magnetic generating means (12a, 12b) in the lengthwise direction.

3. The magnetic sensor according to Claim 1, wherein the magnetic generating means (12a, 12b) and the magnetoresistive element (11) are located on the same substrate flat surface.

4. The magnetic sensor according to Claim 1, wherein the at least one magnetic generating means (12a, 12b) comprises two magnetic generating means (12a, 12b), and the two magnetic generating means (12a, 12b) generate magnetic fields in opposite directions.

5. The magnetic sensor according to Claim 4,
wherein the at least one magnetoresistive element (11) comprises a plurality of magnetoresistive elements (11a-11d) forming a bridge circuit (16),
wherein the magnetic generating means (12a, 12b) are arranged between the bridge circuit (16) and a feeding terminal (14) and between the bridge circuit (16) and a grounding terminal (15), and
wherein, in response to power supply to the bridge circuit (16) through the feeding terminal (14) and the grounding terminal (15), one of the magnetic generating means (12a) generates a magnetic field in a direction toward the magnetic shield (20), and the other magnetic generating means (12b) generates a magnetic field in a direction away from the magnetic shield (20).

6. The magnetic sensor according to Claim 4 or 5, wherein the magnetic generating means (12a, 12b) are flat coils located on the same substrate flat surface (10) as a substrate flat surface on which the magnetoresistive elements (11a-11d) are located, and the two magnetic generating means (12a, 12b) are wound in directions opposite to each other.

7. The magnetic sensor according to any one of Claims 4 to 6, wherein the magnetic shield (20) has a rectangular shape having a lengthwise direction and a widthwise direction in plan view, and opposite ends of the magnetic shield (20) in the lengthwise direction respectively overlap the two magnetic generating means (12a, 12b) in plan view.

8. A current sensor (1A, 3A) comprising the magnetic sensor (1, 2, 3) according to any one of Claims 1 to 7,
the target magnetic field in the magnetic sensor (1, 2, 3) being a magnetic field from a target current to be measured.

## Patentansprüche

1. Magnetsensor (1, 2, 3), aufweisend:
mindestens ein Magnetowiderstandselement (11), eine magnetische Abschirmung (20), die dem Magnetowiderstandselement (11) zugewandt ist und eine Stärke eines an das Magnetowiderstandselement (11) angelegten und zu messenden Zielmagnetfelds reduziert, sowie mindestens eine Magnetismuserzeugungseinrichtung (12a, 12b), die mit dem Magnetowiderstandselement (11) elektrisch verbunden ist,
wobei die Magnetismuserzeugungseinrichtung (12a, 12b) ein Magnetfeld in Reaktion auf eine Energiezufuhr zu der Magnetismuserzeugungseinrichtung (12a, 12b) und dem Magnetowiderstandselement (11) erzeugt,
wobei die magnetische Abschirmung (20) eine rechteckige Form besitzt, die in der Draufsicht eine Längsrichtung und eine Breitenrichtung aufweist, wobei das Magnetowiderstandselement (11) eine Empfindlichkeitsachse in der Breitenrichtung aufweist,
**dadurch gekennzeichnet,**
**dass** das von der Magnetismuserzeugungseinrichtung (12a, 12b) verursachte Magnetfeld in der Längsrichtung durch die magnetische Abschirmung (20) hindurch geht, und
**dass** das Magnetfeld bewirkt, dass ein Vormagnetisierungsfeld an die magnetische Abschirmung (20) angelegt wird, um eine einzige magnetische Domäne in der magnetischen Abschirmung (20) zu bilden.

2. Magnetsensor nach Anspruch 1,
wobei das Magnetowiderstandselement (11) und die Magnetismuserzeugungseinrichtung (12a, 12b) in der Draufsicht in der Längsrichtung angeordnet sind und das Magnetowiderstandselement (11) in der Längsrichtung näher bei einem Zentrum der magnetischen Abschirmung (20) liegt als die Magnetismuserzeugungseinrichtung (12a, 12b).

3. Magnetsensor nach Anspruch 1,
wobei die Magnetismuserzeugungseinrichtung (12a, 12b) und das Magnetowiderstandselement (11) auf der gleichen ebenen Substratoberfläche angeordnet sind.

4. Magnetsensor nach Anspruch 1,
wobei die mindestens eine Magnetismuserzeugungseinrichtung (12a, 12b) zwei Magnetismuserzeugungseinrichtungen (12a, 12b) umfasst und die beiden Magnetismuserzeugungseinrichtungen (12a, 12b) Magnetfelder in entgegengesetzten Richtungen erzeugen.

5. Magnetsensor nach Anspruch 4,
wobei das mindestens eine Magnetowiderstandselement (11) eine Mehrzahl von Magnetowiderstandselementen (11a-11d) umfasst, die eine Brückenschaltung (16) bilden,
wobei die Magnetismuserzeugungseinrichtungen (12a, 12b) zwischen der Brückenschaltung (16) und einem Speiseanschluss (14) und zwischen der Brückenschaltung (16) und einem Erdungsanschluss (15) angeordnet sind, und
wobei in Reaktion auf die Energiezufuhr zu der Brückenschaltung (16) durch den Speiseanschluss (14) und den Erdungsanschluss (15) die eine der Magnetismuserzeugungseinrichtungen (12a) ein Magnetfeld in einer Richtung zu der magnetischen Abschirmung (20) hin erzeugt und die andere der Magnetismuserzeugungseinrichtungen (12b) ein Magnetfeld in einer Richtung von der magnetischen Abschirmung (20) weg erzeugt.

6. Magnetsensor nach Anspruch 4 oder 5,
wobei die Magnetismuserzeugungseinrichtungen (12a, 12b) Flachspulen sind, die sich auf der gleichen ebenen Substratoberfläche (10) befinden wie eine ebene Substratoberfläche, auf der sich die Magnetowiderstandselemente (11a-11d) befinden, und wobei die beiden Magnetismuserzeugungseinrichtungen (12a, 12b) in zueinander entgegengesetzten Richtungen gewickelt sind.

7. Magnetsensor nach einem der Ansprüche 4 bis 6,
wobei die magnetische Abschirmung (20) eine rechteckige Form besitzt, die in der Draufsicht eine Längsrichtung und eine Breitenrichtung aufweist, und wobei gegenüberliegende Enden der magnetischen Abschirmung (20) in der Längsrichtung jeweils die beiden Magnetismuserzeugungseinrichtungen (12a, 12b) in der Draufsicht überlappen.

8. Stromsensor (1A, 3A) mit dem Magnetsensor (1, 2, 3) nach einem der Ansprüche 1 bis 7,
wobei das Zielmagnetfeld in dem Magnetsensor (1, 2, 3) ein Magnetfeld von einem zu messenden Zielstrom ist.

## Revendications

1. Capteur magnétique (1, 2, 3) comprenant au moins un élément magnétorésistif (11), un blindage magnétique (20) faisant face à l'élément magnétorésistif (11) et réduisant une force d'un champ magnétique cible qui est appliquée à l'élément magnétorésistif (11) et qui doit être mesurée, et au moins un moyen générateur de force magnétique (12a, 12b) électriquement connecté à l'élément magnétorésistif (11),
dans lequel le moyen générateur de force magnétique (12a, 12b) génère un champ magnétique en réponse à une alimentation électrique du moyen générateur de force magnétique (12a, 12b) et de l'élément magnétorésistif (11),
dans lequel le blindage magnétique (20) a une forme rectangulaire ayant une direction longitudinale et une direction transversale selon une vue en plan, l'élément magnétorésistif (11) présente une axe de sensibilité dans la direction transversale,
**caractérisé en ce que**
le champ magnétique créé par le moyen générateur de force magnétique (12a, 12b) circule à travers le blindage magnétique (20) dans la direction longitudinale, et
le champ magnétique crée un champ magnétique de polarisation devant être appliqué au blindage magnétique (20) pour former un domaine magnétique unique dans le blindage magnétique (20).

2. Le capteur magnétique selon la revendication 1, dans lequel l'élément magnétorésistif (11) et le moyen générateur de force magnétique (12a, 12b) sont disposés dans la direction longitudinale selon une vue en plan, et où l'élément magnétorésistif (11) est plus près d'un centre du blindage magnétique (20) que le moyen générateur de force magnétique (12a, 12b) dans la direction longitudinale.

3. Le capteur magnétique selon la revendication 1, dans lequel le moyen générateur de force magnétique (12a, 12b) et l'élément magnétorésistif (11) sont situés sur la même surface de substrat plate.

4. Le capteur magnétique selon la revendication 1, dans lequel le moyen générateur de force magnétique (12a, 12b), un au moins, comprend deux moyens générateurs de force magnétique (12a, 12b), et où les deux moyens générateurs de force magnétique (12a, 12b) génèrent des champs magnétiques dans des directions opposées.

5. Le capteur magnétique selon la revendication 4,
dans lequel l'élément magnétorésistif (11), un au moins, comprend une pluralité d'éléments magnétorésistifs (11a-11d) formant un circuit en pont (16),
dans lequel les moyens générateurs de force magnétique (12a, 12b) sont disposés entre le circuit en pont (16) et une borne d'alimentation (14) et entre le circuit en pont (16) et une borne de terre (15), et
dans lequel, en réponse à l'alimentation électrique du circuit en pont (16) par la borne d'alimentation (14) et la borne de terre (15), un des moyens générateurs de force magnétique (12a) génère un champ magnétique dans une direction allant vers le blindage magnétique (20), et l'autre moyen générateur de force magnétique (12b) génère un champ magnétique dans une direction s'éloignant du blindage magnétique (20).

6. Le capteur magnétique selon la revendication 4 ou 5, dans lequel les moyens générateurs de force magnétique (12a, 12b) sont des bobines plates situées sur la même surface de substrat plate (10) en tant que surface de substrat plate sur laquelle les éléments magnétorésistifs (11a-11d) sont situés, et où les deux moyens générateurs de force magnétique (12a, 12b) sont enroulés dans des directions opposées l'une de l'autre.

7. Le capteur magnétique selon l'une quelconque des revendications 4 à 6, dans lequel le blindage magnétique (20) a une forme rectangulaire ayant une direction longitudinale et une direction transversale selon une vue en plan, et où les extrémités opposées du blindage magnétique (20) dans la direction longitudinale chevauchent respectivement les deux moyens générateurs de force magnétique (12a, 12b) selon une vue en plan.

8. Capteur de courant (1A, 3A) comprenant le capteur magnétique (1, 2, 3) selon l'une quelconque des revendications 1 à 7,
le champ magnétique cible dans le capteur magnétique (1, 2, 3) étant un champ magnétique provenant d'un courant cible à mesurer.
